# FASCICULE DE BREVET EUROPEEN

(11) **EP 0 388 569 B1**
(45) Date de publication et mention de la délivrance du brevet: **18.05.1994**
(21) Numéro de dépôt: 89420498.1
(22) Date de dépôt: 19.12.1989
(51) Int. Cl.: G01R 19/165, H03K 17/22

(54) **Circuit de détection de chute de tension d'alimentation et de réarmement d'un circuit d'initialisation**
Schaltung zur Feststellung eines Versorgungsspannungsabfalls sowie zur Wiederherstellung des Beginnschaltzustands
Circuit to detect a voltage power drop and to restore the initial circuit condition

(30) Priorité: 22.12.1988 FR 8817364
(43) Date de publication de la demande: 26.09.1990
(73) Titulaire: SGS-THOMSON MICROELECTRONICS S.A., 94250 Gentilly (FR)
(72) Inventeur: Queinnec, Olivier, 67100 Strasbourg (FR); Pouget, Henri, F-38100 Grenoble (FR)
(74) Mandataire: de Beaumont, Michel

(56) Documents cités:
- EP-A- 0 127 139
- FR-A- 2 278 208
- FR-A- 2 400 710
- FR-A- 2 449 898
- US-A- 4 473 759
- US-A- 4 716 323

## Description

La présente invention concerne un circuit de détection de chute de tension d'alimentation et de réarmement d'un circuit d'initialisation, réalisable dans un circuit intégré de type MOS sans composants externes.

Dans un circuit intégré logique de type MOS, il faut prévoir lors de la mise sous tension une réinitialisation du circuit. De nombreux circuits ont été prévus dans ce but. Un inconvénient de ces circuits d'initialisation est que, en raison de capacités qu'ils incorporent ou de capacités parasites qui leur sont associées, ils ne peuvent être remis en oeuvre après des chutes d'alimentation brèves.

En conséquence, la présente invention prévoit un circuit de détection particulièrement simple de la chute d'une tension d'alimentation appliquée à un circuit intégré de type MOS et l'utilisation de ce circuit au réarmement d'un circuit d'initialisation.

Pour atteindre cet objet, la présente invention prévoit un circuit de détection d'une chute de tension d'alimentation fournie entre une borne d'alimentation haute et une borne d'alimentation basse d'un circuit intégré, comprenant :
- un circuit à seuil comprenant une borne d'entrée reliée à la borne d'alimentation haute, une borne de sortie fournissant le signal recherché et des bornes d'entrée d'alimentation,
- un condensateur MOS connecté entre lesdites bornes d'entrée d'alimentation et dont la première borne est reliée à la borne d'alimentation basse, et
- un transistor MOS à canal N dont la source est reliée à la deuxième borne dudit condensateur et dont le drain et la grille sont reliés ensemble à la borne d'alimentation haute.

Un avantage de ce circuit est qu'il est particulièrement simple et occupe une faible surface de circuit intégré.

Ces objets, caractéristiques et avantages de la présente invention seront exposés plus en détail dans la description suivante d'un mode de réalisation particulier faite en relation avec les figures jointes parmi lesquelles :
la figure 1 représente un mode de réalisation d'un circuit selon la présente invention;
la figure 2 représente l'allure de signaux en divers points du circuit de la figure 1 ; et
la figure 3 représente une application du circuit selon la présente invention au réarmement d'un circuit d'initialisation.

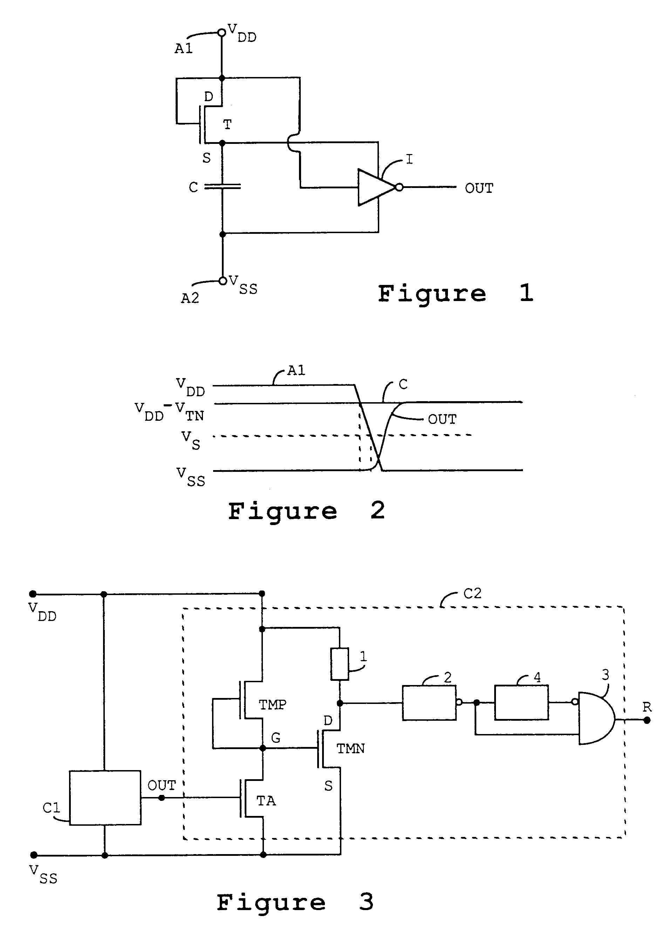

Le circuit de la figure 1 est alimenté entre une borne d'alimentation haute A1 destinée à recevoir une tension V_{DD} et une borne d'alimentation basse A2 à un potentiel V_{SS}. Pour la simplicité de l'exposé, on supposera ci-après que V_{SS} est égal à zéro. Sinon, il suffira de remplacer partout V_{DD} par V_{DD}-V_{SS}.

Entre les bornes A1 et A2 sont connectés en série un transistor MOS à canal N, T, et un condensateur MOS C. Le drain du transistor T est relié à sa grille et à la borne A1. Un inverseur I est alimenté aux bornes du condensateur C et recoit à son entrée le signal V_{DD}. La sortie de cet inverseur est désignée par OUT.

Le fonctionnement de ce circuit va être exposé en relation avec les formes d'ondes de la figure 2. Dans cette figure, la tension sur la borne d'alimentation haute est désignée par la référence A1, la tension aux bornes du condensateur par la référence C et la tension de sortie par la référence OUT.

Si l'on part d'un état où la tension sur la borne A1 est égale à V_{DD}, la tension aux bornes du condensateur C sera V_{DD}-V_{TN}, V_{TN} étant la tension de seuil du transistor à canal N. En ce cas, la tension OUT est égale à 0 (V_{SS}). Si la tension sur la borne A1 chute, le transistor T se bloque et la tension V_{DD}-V_{TN} est mémorisée aux bornes du condensateur C qui se décharge ensuite lentement selon les fuites de jonction et qui maintient l'alimentation aux bornes de l'inverseur I. Ensuite, si la tension sur la borne A1 chute en dessous de la valeur de seuil VS de l'inverseur I, la sortie de cet inverseur change d'état et passe à sa valeur haute, sensiblement égale à V_{DD}-V_{TN}. On obtient donc bien à la sortie OUT une indication d'une chute de tension au-dessous de la tension de seuil de l'inverseur I. L'homme de l'art saura choisir un inverseur fournissant une tension de seuil recherchée en dessous de laquelle on doit considérer que la tension d'alimentation est devenue trop faible.

On notera d'ailleurs que l'on a mentionné ci-dessus par souci de simplicité l'utilisation d'un inverseur mais que tout circuit présentant un changement d'état par suite de la chute de sa tension d'entrée en dessous d'un niveau de seuil pourra convenir.

La figure 3 représente une utilisation du circuit selon la présente invention au réarmement d'un circuit d'initialisation. Le circuit selon la présente invention est désigné par la référence C1 et le circuit d'initialisation par la référence C2. La sortie OUT du circuit C1, correspondant à la sortie OUT de la figure 1, est reliée à l'entrée de réarmement du circuit C2.

On a représenté à l'intérieur du bloc C2 un exemple de circuit de réinitialisation. Ce circuit C2 comprend un transistor MOS de type N TMN dont le drain est relié à la borne V_{DD} par une impédance 1, dont la grille G est reliée à la grille et au drain d'un transistor MOS à canal P TMP. La source du transistor TMP est reliée à V_{DD} et la source du transistor TMN est reliée à V_{SS}. En outre, il est prévu des moyens pour mettre en forme et détecter la sortie du circuit d'initialisation connectée au drain du transistor TMN et comprenant un circuit inverseur de mise en forme de signal 2 dont la sortie est envoyée, d'une part, à une entrée non-inverseuse d'une porte ET 3, d'autre part, à une entrée inverseuse de cette porte ET par l'intermédiaire d'un circuit de retard 4. La sortie R de la porte ET 3 constitue le signal de réinitialisation.

Le circuit C2 permet la détection du passage de la tension V_{DD} au dessus d'un seuil donné égal au seuil du transistor TMP plus le seuil du transistor TMN. Néanmoins, si la tension chute, ce circuit ne se décharge que très lentement et il n'est pas émis de signal de réinitialisation lors de la remontée de la tension d'alimentation.

Selon l'invention, il est adjoint à ce circuit un transistor de réarmement TA qui est un transistor MOS à canal N dont le drain est relié à la borne G et la source à V_{SS}. La grille du transistor TA reçoit le signal OUT. Ainsi, quand le signal OUT est à bas niveau, ce transistor est bloqué et le circuit C2 fonctionne normalement. Par contre, dès que la tension chute et qu'un signal OUT est fourni, le transistor TA devient conducteur et ramène à bas niveau la tension de grille des transistors TMP et TMN, permettant de redétecter ensuite une croissance de la tension V_{DD}, cette nouvelle montée de V_{DD} ramenant le signal OUT à bas niveau.

Bien entendu, la présente invention est susceptible de nombreuses variantes et modifications qui apparaîtront à l'homme de l'art. Notamment, si les polarités relatives des tensions V_{DD} et V_{SS} sont inversées, il conviendra de modifier tous les types de transistors MOS pour que le circuit fonctionne de façon correspondante.

## Revendications

1. Circuit de détection d'une chute de tension d'alimentation fournie entre une borne d'alimentation haute (A1) et une borne d'alimentation basse (A2) d'un circuit intégré, caractérisé en ce qu'il comprend :
- un circuit à seuil (I) comprenant une borne d'entrée reliée à la borne d'alimentation haute, une borne de sortie fournissant le signal recherché (OUT) et des bornes d'entrée d'alimentation,
- un condensateur MOS (C) connecté entre lesdites bornes d'entrée d'alimentation et dont la première borne est reliée à la borne d'alimentation basse, et
- un transistor MOS à canal N (T) dont la source est reliée à la deuxième borne dudit condensateur et dont le drain et la grille sont reliés ensemble à la borne d'alimentation haute.

2. Circuit de détection selon la revendication 1, caractérisé en ce que ledit circuit à seuil (I) est un inverseur.

3. Circuit de détection selon la revendication 1, caractérisé en ce que la borne de sortie du circuit à seuil (I) est reliée à l'entrée de réarmement d'un circuit d'initialisation (C2) à la mise sous tension pour un circuit intégré CMOS.

4. Circuit de détection selon la revendication 3, caractérisé en ce que la borne de sortie du circuit à seuil (OUT) est reliée à la grille d'un transistor de réarmement (TA) qui est un transistor MOS à canal N dont la source est reliée à la borne (A2) d'alimentation basse, et dont le drain est relié d'une part à la grille et au drain d'un transistor MOS à canal P (TMP) et d'autre part à la grille d'un transistor à canal N (TMN), la source du transistor à canal P (TMP) étant reliée à la borne (A1) d'alimentation haute, la source du transistor à canal N (TMN) étant reliée à la borne (A2) d'alimentation basse, le drain du transistor à canal N (TMN) étant relié d'une part à la borne (A1) d'alimentation haute par une impédance (1) et d'autre part à un circuit de mise en forme de signal (2, 3, 4).

## Claims

1. A circuit for detecting the drop of the supply voltage supplied between a high supply terminal (A1) and a low supply terminal (A2) of an integrated circuit, characterized in that it comprises:
- a threshold circuit (I) comprising an input terminal connected to the high supply terminal, an output terminal supplying the desired signal (OUT), and supply input terminals,
- a MOS capacitor (C) connected between said supply input terminals, the first terminal of which is connected to the low supply terminal, and
- an N-channel MOS transistor (T), the source of which is connected to the second terminal of said capacitor and the drain and gate of which are interconnected to the high supply terminal.

2. A detection circuit according to claim 1, characterized in that said threshold circuit (I) is an inverter.

3. A detection circuit according to claim 1, characterized in that the output terminal of the threshold circuit is connected to the reset input of a circuit (C2) for initialization at the powering of a MOS integrated circuit.

4. A detection circuit according to claim 3, characterized in that the output terminal of the threshold circuit (OUT) is connected to the gate of a resetting transistor (TA) which is an N-channel MOS transistor, the source of which is connected to the low supply terminal (A2) and the drain of which is connected to the gate and drain of a P-channel MOS transistor (TMP) and to the gate of an N-channel MOS transistor (TMN), the source of the P-channel transistor (TMP) being connected to the high supply terminal (A1), the source of the N-channel transistor (TMN) being connected to the low supply terminal (A2), the drain of the N-channel MOS transistor being connected to the high supply terminal (A1) through an impedance (1) and to a signal shaping circuit (2, 3, 4).

## Patentansprüche

1. Schaltung zum Erfassen eines Abfalls der Versorgungsspannung, die zwischen einem Anschluß (A1) hoher Versorgung und einem Anschluß (A2) niedriger Versorgung eines integrierten Schaltkreises geliefert wird, dadurch gekennzeichnet, daß sie aufweist:
- eine Schwellenschaltung (I), mit einem Eingangsanschluß, der mit dem Anschluß hoher Versorgung verbunden ist, einem Ausgangsanschluß, der das gesuchte Signal (OUT) liefert, und Eingangsanschlüssen für die Versorgung,
- einen MOS-Kondensator (C), der zwischen die Eingangsanschlüsse für die Versorgung geschaltet ist und dessen erster Anschluß mit dem Anschluß niedriger Versorgung verbunden ist, und
- einen N-Kanal-MOS-Transistor (T), dessen Source mit dem zweiten Anschluß des Kondensators verbunden ist und dessen Drain und Gate zusammen mit dem Anschluß hoher Versorgung verbunden sind.

2. Erfassungsschaltkreis nach Anspruch 1, dadurch gekennzeichnet, daß die Schwellenschaltung (I) ein Inverter ist.

3. Erfassungsschaltkreis nach Anspruch 1, dadurch gekennzeichnet, daß der Ausgangsanschluß der Schwellenschaltung (I) mit dem Rückstelleingang einer Initialisierungsschaltung (C2) für das unter Spannung Setzen einer integrierten CMOS-Schaltung verbunden ist.

4. Erfassungsschaltkreis nach Anspruch 3, dadurch gekennzeichnet, daß der Ausgangsanschluß (OUT) der Schwellenschaltung mit dem Gate eines Rückstelltransistors (TA) verbunden ist, der ein N-Kanal-MOS-Transistor ist, dessen Source mit dem Anschluß (A2) für niedrige Versorgung verbunden ist und dessen Drain einerseits mit dem Gate und dem Drain eines P-Kanal-MOS-Transistors (TMP) und andererseits mit dem Gate eines N-Kanal-Transistors (TMN) verbunden ist, wobei die Source des P-Kanal-Transistors (TMP) mit dem Anschluß (A1) hoher Versorgung verbunden ist, wobei die Source des N-Kanal-Transistors (TMN) mit dem Anschluß (A2) niedriger Versorgung verbunden ist, wobei der Drain des N-Kanal-Transistors (TMN) einerseits mit dem Anschluß (A1) hoher Versorgung über eine Impedanz (1) und andererseits mit einer Signalformungsschaltung (2, 3, 4) verbunden ist.
